(19)

Europäisches
Patentamt
European
Patent Office
Office européen
des brevets

(11) **EP 3 650 986 A1**

(12) **EUROPEAN PATENT APPLICATION**

(43) Date of publication:
**13.05.2020 Bulletin 2020/20**

(21) Application number: **18205065.8**

(22) Date of filing: **08.11.2018**

(51) Int Cl.:
*G06F 3/01* (2006.01)          *G02F 1/1333* (2006.01)
*G06F 3/041* (2006.01)          *H01L 41/193* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Robert Bosch GmbH
70442 Stuttgart (DE)**

(72) Inventors:
- **Beruscha, Frank
  71665 Kleinglattbach (DE)**
- **So, Yong Heng
  564596 Singapur (SG)**

(54) **HAPTIC FEEDBACK SCREEN AND FLAT SCREEN COMPRISING A HAPTIC FEEDBACK SCREEN**

(57)     A haptic feedback screen may include a transparent electroactive polymer layer, between a first transparent electrode and a second transparent electrode. The haptic feedback screen may further include a gap between the first transparent electrode and the transparent electroactive polymer layer. The gap may be filled with a fluid transparent dielectric material. The fluid transparent dielectric material may be selected so that its refractive index is between +/-0.2 of any of the refractive index of the transparent electroactive polymer layer and the refractive index of the first transparent electrode or between the refractive index of the transparent electroactive polymer layer and the first transparent electrode. A flat panel display including a first layer including a matrix with light elements and a second layer over the first layer, the second layer including the haptic feedback screen.

FIG. 1B

**Description**

**TECHNICAL FIELD**

The present disclosure relates to a haptic feedback screen and to a flat screen comprising a haptic feedback screen.

**BACKGROUND**

Conventional touch screens are not able to provide haptic feedback. Most devices having some form of haptic feedback provide such feedback in the form of a vibration of the whole device. This vibration is not localized and requires rather bulky electromechanical motors.

Therefore, there is a need to provide for providing improved haptic feedback, for example for a touch screen or a flat screen.

**SUMMARY**

It is therefore, object of the invention to provide an improved haptic feedback screen. It is a further object to provide a flat screen comprising a haptic feedback screen.

Various embodiments relate to a haptic feedback screen. The haptic feedback screen may include a transparent electroactive polymer layer between a first transparent electrode and a second transparent electrode. The haptic feedback screen may further include a gap between the first transparent electrode and the transparent electroactive polymer layer. The gap may be filled with a fluid transparent dielectric material including a refractive index ($n_{gap}$). The fluid transparent dielectric material may be selected so that the refractive index ($n_{gap}$) is between +/-0.2 of any of the refractive index of the transparent electroactive polymer layer and the refractive index of the first transparent electrode. Alternatively or in addition, the fluid transparent dielectric material may be selected so that the refractive index ($n_{gap}$) is between the refractive index of the transparent electroactive polymer layer and the refractive index of the first transparent electrode.

Various embodiments may relate to a flat panel display including a first layer including a matrix with light elements and a second layer over the first layer, the second layer including the haptic feedback screen.

**BRIEF DESCRIPTION OF THE DRAWINGS**

In the following description, various embodiments of the present disclosure are described with reference to the following drawings, in which:

- Fig. 1A shows a schematic illustration of a haptic feedback screen 100, including a transparent electroactive polymer layer 130, between a first transparent electrode 110 and a second transparent electrode 140 and a gap 120 between the first transparent electrode 110 and the transparent electroactive polymer layer 130;
- FIG. 1B shows the haptic feedback screen 100 wherein a pressure is applied to the first transparent electrode 110;
- Fig. 2 shows a schematic illustration of a haptic feedback screen 102, wherein a gap is defined by spacers 162 which are formed on the first transparent electrode 110;
- Fig. 3 shows a schematic illustration of a haptic feedback screen 104, which is identical to the haptic feedback screen 102, with the difference that spacers, now numbered as 164, are formed on the transparent electroactive polymer layer 130;
- Fig. 4 shows a schematic illustration of a haptic feedback screen 106, wherein a gap is defined by spacers 162 which are formed on the transparent electroactive polymer layer 130;
- Fig. 5 shows a schematic illustration of a haptic feedback screen 108, which is identical to the haptic feedback screen 106, with the difference that spacers, now numbered as 168, are formed on the first transparent electrode 110.

The figures show layered devices in schematic illustrations and which may not be up to scale. For example one or more layers may be thicker or thinner in relation to other layers.

**DETAILED DESCRIPTION**

The following detailed description describes specific details and embodiments in which the invention may be practiced. These embodiments are described in sufficient detail to enable those skilled in the art to practice the invention. Other embodiments may be utilized and changes may be made without departing from the scope of the invention. The various embodiments are not necessarily mutually exclusive, as some embodiments can be combined with one or more other embodiments to form new embodiments.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

The invention illustratively described herein may suitably be practiced in the absence of any element or elements, limitation or limitations, not specifically disclosed herein. Thus, for example, the terms "comprising", "including," containing", etc. shall be read expansively and without limitation. The word "comprise" or variations such as "comprises" or "comprising" will accordingly be understood to imply the inclusion of a stated integer or groups of integers but not the exclusion of any other integer or group of integers. Additionally, the terms and expressions employed herein have been used as terms of description and not of limitation, and there is no intention in the use of such terms and expressions of excluding any equivalents of the features shown and described or portions thereof, but it is recognized that various modifications are possible within the scope of the invention claimed. Thus, it should be understood that although the present invention has been specifically disclosed by exemplary embodiments and optional features, modification and variation of the inventions embodied herein disclosed may be resorted to by those skilled in the art, and that such modifications and variations are considered to be within the scope of this invention.

Within the context of the present disclosure, and according to various embodiments, each of the electrodes and the substrate may be transparent, and are therefore named as such. For example as first transparent electrode.

Within the context of the present disclosure, and according to various embodiments, the electrodes and the substrate, for example the first transparent electrode, the second transparent electrode, and the substrate, may each be provided in the form of layers.

Various embodiments relate to a haptic feedback screen. The haptic feedback screen is configured such that upon application of sufficient pressure (for example a touch of an user) which defines a touch event, a mechanical feedback is provided, for example in that the transparent electroactive polymer layer is momentarily mechanically deformed, due to the application of electrical signal, therefore providing the haptic feedback. As the touch event may also be recorded, for example by a suitable touch controller, the haptic feedback screen may be implemented as a touch screen with haptic feedback.

According to various embodiments, the haptic feedback screen may include a transparent electroactive polymer layer, between a first transparent electrode and a second transparent electrode. The haptic feedback screen may further include a gap between the first transparent electrode and the transparent electroactive polymer layer. The gap may be filled with a fluid transparent dielectric material. The touch event takes place when an electric contact is established between the first transparent electrode and the transparent electroactive polymer layer, since the gap is filled with the fluid transparent dielectric material, the electric contact is established on a mechanical contact between the first transparent electrode and the transparent electroactive polymer layer.

The refractive index of the fluid transparent dielectric material ($n_{gap}$) may be selected to be between the refractive index of the transparent electroactive polymer layer ($n_{EAP}$) and the refractive index of the first transparent electrode ($n_{el1}$), according to Relation 1:

$$\text{If } n_{el1} < n_{EAP}: n_{el1} < n_{gap} < n_{EAP}$$
$$\text{If } n_{el1} > n_{EAP}: n_{el1} > n_{gap} > n_{EAP} \qquad \text{(Relation 1)}$$
$$\text{If } n_{el1} = n_{EAP}: n_{el1} = n_{gap} = n_{EAP}$$

In addition, the refractive index of the fluid transparent dielectric material ($n_{gap}$) may be further selected so that the $n_{gap}$ does not differ from either $n_{EAP}$ or $n_{el1}$ by more than 10% of the delta $n_{EAP} - n_{el1}$ (absolute value), in accordance with relation 2 or relation 3:

$$n_{EAP} - 0.1*abs(n_{EAP} - n_{el1}) <= n_{gap} <= n_{EAP} + 0.1*abs(n_{EAP} - n_{el1}) \qquad \text{(Relation 2)}$$

$$n_{el1} - 0.1*abs(n_{EAP} - n_{el1}) <= n_{gap} <= n_{el1} + 0.1*abs(n_{EAP} - n_{el1}) \qquad \text{(Relation 3);}$$

wherein "abs($n_{EAP} - n_{el1}$)" refers to the absolute value of ($n_{EAP} - n_{el1}$).

According to various embodiments, the haptic feedback screen may further include a transparent substrate, wherein the first transparent electrode is closer to the substrate than the second transparent electrode and wherein the second transparent electrode is flexible, or wherein the second transparent electrode is closer to the substrate than the first transparent electrode, and wherein each of the second transparent electrode and the transparent electroactive polymer layer are flexible.

According to various embodiments, the haptic feedback screen may further include a dielectric spacer for defining a gap distance of the gap. The dielectric spacer is insulating, and may comprise or consist of a transparent and/or flexible material.

According to various embodiments, a material of the dielectric spacer is selected so that the refractive index of the dielectric spacer ($n_{spc}$) is between the refractive index of the transparent electroactive polymer layer ($n_{EAP}$) and the first transparent electrode ($n_{el1}$) or with a difference of at least +/-0.2 therefrom. The spacer may be transparent, and may be selected so that the refractive index of the spacer ($n_{spc}$) obeys the same relations as the refractive index of the fluid transparent dielectric material ($n_{gap}$).

According to various embodiments, the spacer may be provided on the gap side which is closer to the substrate.

According to various embodiments, the spacer may be provided on the gap side which is further from the substrate. The substrate may include poly(ethylene terephthalate).

According to various embodiments, the dielectric spacer may be a set of dot spacers.

According to various embodiments, the first transparent electrode may include a transparent conductor material, for example indium-tin-oxide (ITO), poly(3,4-ethylenedioxythiophene) polystyrene sulfonate (PEDOT-PSS), Silver nanowires (AgNWs), conductive carbon nanotubes (CNTs), or a mixture thereof. These transparent conductor materials may include further additives to enhance electrical and/or physical layer properties.

According to various embodiments, the second transparent electrode may include a transparent conductor material, for example indium-tin-oxide (ITO), poly(3,4-ethylenedioxythiophene) polystyrene sulfonate (PEDOT-PSS), Silver nanowires (AgNWs), conductive carbon nanotubes (CNTs), or a mixture thereof. These transparent conductor materials may include further additives to enhance electrical and/or physical layer properties.

According to various embodiments, the transparent electroactive polymer layer may include or may consist of an electroactive material. The term "electroactive material" may mean a material which may undergo a shape change in response to an applied electrical field, which material (and layer) may further emit an electrical signal upon mechanical stimulation. The electrical signal may be detected via electrodes coupled to the layer.

According to various embodiments the transparent electroactive polymer layer may include a piezo electro active polymer (piezoEAP). Examples of piezoEAPs are: FerroEAPs such as poly (vinylidenefluoride - trifluoroethylene - chlorotrifluoroethylene) abbreviated as P(VDF-TrFE-CTFE), poly(vinylidenefluoride-trifluoroethylene-chlorofluoroethylene) abbreviated as P(VDF-TrFE-CFE), poly(vinylidenefluoride - trifluoroethylene - hexafluoropropylene) abbreviated as P(VDF-TrFE-HFP), and poly[ (vinylidenefluoride - co - trifluoroethylene] abbreviated as P(VDF-TrFE), poly[( vinylidenefluoride - co - hexafluoropropylene] abbreviated as P(VDF-HFP), poly[ (vinylidenefluoride - co - chlorotrifluoroethylene] abbreviated as P(VDF-CTFE).

Substrate

Gap and Spacers

Within the context of the present disclosure, and according to various embodiments, the dielectric spacer is insulating.

Refractive Index and fluid/liquid material

Within the context of the present disclosure, and according to various embodiments, the fluid transparent dielectric material is insulating. The fluid transparent dielectric material may be a liquid. For example, when pressure is applied on a specific area, the liquid can flow to surrounding areas, which would then expand slightly. This is possible as the whole screen is flexible to some extent.

Within the context of the present disclosure, and according to various embodiments, the refractive index may refer at least to the refractive index at 550 nm, for example the refractive index at any wavelength between 400 nm and 700 nm under Normal Temperature and Pressure (NTP). NTP is defined as temperature of 20 °C and pressure of 1 atm.

Within the context of the present disclosure, and according to various embodiments, the term "transparency" or "transparent" may mean a regular transmittance of at least 0.6 or above, at least at 550 nm, for example at any wavelength in the wavelength range of 400 nm to 700 nm. For example, a transparent layer may refer to a layer including a regular transmittance of at least 0.6 or above, at least at 550 nm, for example at any wavelength in the wavelength range of 400 nm to 700 nm. The transmittance measurement may be made under NTP.

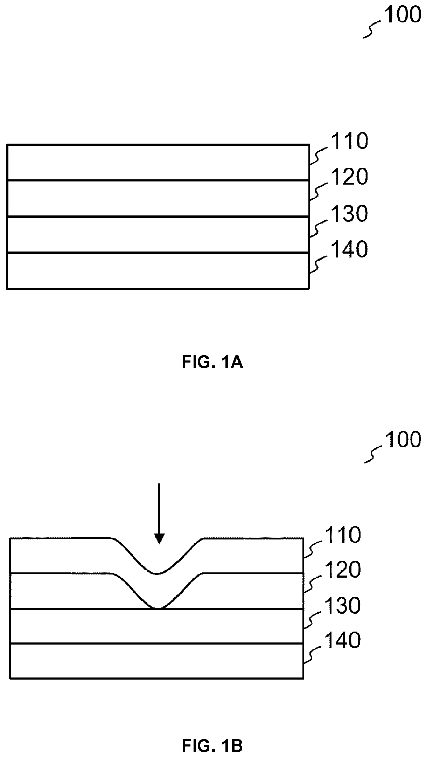

Fig. 1A shows a schematic illustration of a haptic feedback screen 100, including a transparent electroactive polymer layer 130, between a first transparent electrode 110 and a second transparent electrode 140 and a gap 120 between the first transparent electrode 110 and the transparent electroactive polymer layer 130. The gap may include, for example may be filled with, the fluid transparent dielectric material. The electrodes and the substrate are each provided in the form of layers. The haptic feedback screen 100 may further include a substrate, for example on the side of the first transparent electrode 110 or on the side of the second transparent electrode 140. A cover protection layer may further be included, for example on the side which is opposed to the substrate.

According to various embodiments, the first transparent electrode 110 may be flexible. Alternatively or in addition, the second transparent electrode 140 and the transparent electroactive polymer layer 130 may be flexible. FIG. 1B shows an example wherein the first transparent electrode 110 is flexible and wherein a pressure (indicated by the arrow) is applied to the haptic feedback screen 100. Due to the application of the pressure, the first transparent electrode 110 contacts the transparent electroactive polymer layer 130, closing the electric circuit, which may cause the transparent electroactive polymer layer to be momentarily mechanically deformed, due to the application of electrical signal, therefore providing the haptic feedback. As the touch event may also be recorded, for example by a suitable touch controller, the haptic feedback screen may be implemented as a touch screen with haptic feedback.

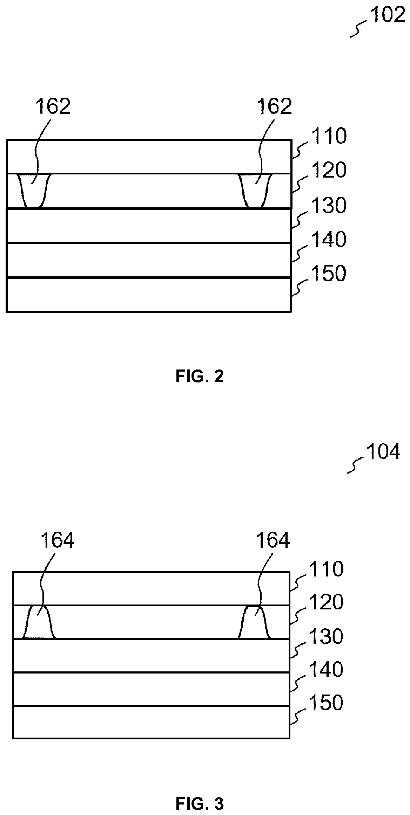

Fig. 2 shows a schematic illustration of a haptic feedback screen 102, including a transparent electroactive polymer layer 130, between a first transparent electrode 110 and a second transparent electrode 140, and a gap 120 between the first transparent electrode 110 and the transparent electroactive polymer layer 130, and further including a substrate 150 which is closer to the second transparent electrode 140 than to the first transparent electrode 110. The gap may include, for example may be filled with, the fluid transparent dielectric material. The electrodes and the substrate are each provided in the form of layers. In this case the pressure, for example, applied by a user, may be applied on the first transparent electrode side (on top as shown in the figure). The gap is filled with the fluid transparent dielectric material. In the haptic feedback screen 102, the gap 120 is defined by spacers 162 which are formed on the first transparent electrode 110. For example, the spacers may include a height such as to keep the transparent electroactive polymer layer 130 and the first transparent electrode 110 apart by a fixed distance corresponding to the spacers' height (when no relevant pressure is applied to the haptic feedback screen). The spacers are schematically illustrated with a larger side (side facing layer 110) and a smaller side (side facing layer 130), the larger side represents the side on which the spacer may be formed on the layer. This representation of the spacer geometry (as used in FIGs. 2-5) is for illustration purposes only, as any other suitable geometry of spacers may be provided.

Fig. 3 shows a schematic illustration of a haptic feedback screen 104, which is identical to the haptic feedback screen 102, with the difference that spacers, now numbered as 164, are formed on the transparent electroactive polymer layer 130, as indicated by the larger side of the spacers contacting the transparent electroactive polymer layer 130.

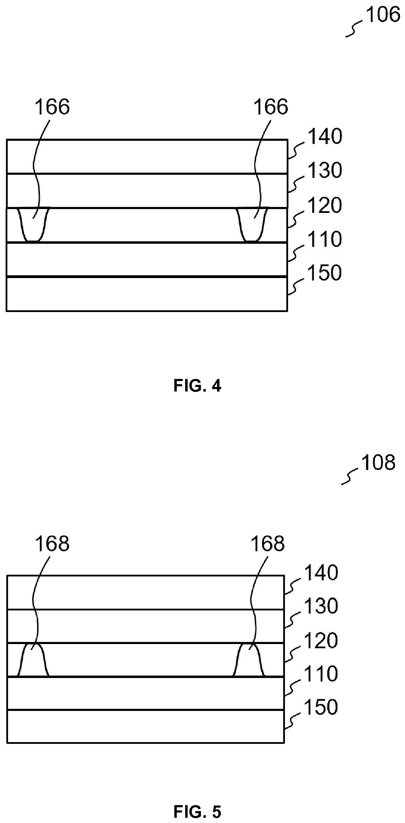

Fig. 4 shows a schematic illustration of a haptic feedback screen 106, including a transparent electroactive polymer layer 130, between a first transparent electrode 110 and a second transparent electrode 140 and a gap 120 between the first transparent electrode 110 and the transparent electroactive polymer layer 130, and further including a substrate 150 which is closer to the first transparent electrode 110 than to the second transparent electrode 140. The gap may include, for example may be filled with, the fluid transparent dielectric material. The electrodes and the substrate are each provided in the form of layers. In this case the pressure, for example, applied by a user, may be applied on the second transparent electrode 140 (on top as shown in the figure). The gap is filled with the fluid transparent dielectric material. The gap 120 is defined by spacers 162 which are formed on the transparent electroactive polymer layer 130. For example, the spacers may include a height such as to keep the transparent electroactive polymer layer 130 and the first transparent electrode 110 apart by a fixed distance corresponding to the spacers' height (when no relevant pressure is applied to the haptic feedback screen).

Fig. 5 shows a schematic illustration of a haptic feedback screen 108, which is identical to the haptic feedback screen 106, with the difference that spacers, now numbered as 168, are formed on the first transparent electrode 110, as indicated by the larger side of the spacers contacting the first transparent electrode 110.

According to various embodiments, as all layers (including the electrodes) are transparent, the haptic feedback screen may be adapted to any surface, which surface thereby remains visible to a user and becomes a touch sensitive surface with haptic feedback. For example a flat panel display may include a first layer comprising a matrix with light elements and a second layer over the first layer, the second layer comprising the haptic feedback screen, thus providing a flat panel display with a touch sensitive surface including haptic feedback.

## Claims

1. A haptic feedback screen (100, 102, 104, 106, 108) comprising:

   a transparent electroactive polymer layer (130) between a first transparent electrode (110) and a second transparent electrode (140),

a gap (120) between the first transparent electrode (110) and the transparent electroactive polymer layer (130); wherein the gap (120) is filled with a fluid transparent dielectric material including a refractive index, and wherein the fluid transparent dielectric material is selected so that its refractive index is between +/-0.2 of any of the refractive index of the transparent electroactive polymer layer (130) and the refractive index of the first transparent electrode (110) or between the refractive index of the transparent electroactive polymer layer (130) and the refractive index of the first transparent electrode (110).

2. The haptic feedback screen (100, 102, 104, 106, 108) of claim 1, further comprising a transparent substrate (150), wherein the first transparent electrode (110) is closer to the substrate (150) than the second transparent electrode (140), and wherein the second transparent electrode (140) is flexible, or wherein the second transparent electrode (140) is closer to the substrate (150) than the first transparent electrode (110), and wherein each of the second transparent electrode (140) and the transparent electroactive polymer layer (130) are flexible.

3. The haptic feedback screen (102, 104, 106, 108) of any of the previous claims, further comprising a dielectric spacer (162, 164, 166, 168) for defining a gap distance of the gap (120).

4. The haptic feedback screen (102, 104, 106, 108) of any of the previous claims, wherein a material of the dielectric spacer (162, 164, 166, 168) is selected so that a refractive index of the dielectric spacer (162, 164, 166, 168) is between the refractive index of the transparent electroactive polymer layer (130) and the first electrode (110) or with a difference of at least +/-0.2 therefrom.

5. The haptic feedback screen (102, 104, 106, 108) of any of claims 2 to 4, wherein the spacer (162, 164, 166, 168) is provided on a gap side which is closer to the substrate (150).

6. The haptic feedback screen (102, 104, 106, 108) of any of claims 2 to 4, wherein the spacer (162, 164, 166, 168) is provided on a gap side which is further from the substrate (150).

7. The haptic feedback screen (102, 104, 106, 108) of any of claims 3 to 6, wherein the dielectric spacer (162, 164, 166, 168) is a set of dot spacers.

8. A flat panel display comprising a first layer comprising a matrix with light elements and a second layer over the first layer, the second layer comprising the haptic feedback screen (100, 102, 104, 106, 108) according to any of the previous claims.

100

110
120
130
140

**FIG. 1A**

100

110
120
130
140

**FIG. 1B**

102

162                    162

110
120
130
140
150

**FIG. 2**

104

164                    164

110
120
130
140
150

**FIG. 3**

106

166 166

140
130
120
110
150

**FIG. 4**

108

168 168

140
130
120
110
150

**FIG. 5**

Europäisches
Patentamt

European
Patent Office

Office européen
des brevets

## EUROPEAN SEARCH REPORT

Application Number

EP 18 20 5065

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 3 187 973 A1 (LG DISPLAY CO LTD [KR]) 5 July 2017 (2017-07-05) <br> * paragraph [0006] - paragraph [0009] * <br> * paragraph [0025] - paragraph [0029] * <br> * paragraph [0042] - paragraph [0045] * <br> * paragraph [0060] - paragraph [0070] * <br> * paragraph [0082] - paragraph [0083] * <br> * paragraph [0099] - paragraph [0104] * <br> ----- | 1-8 | INV. <br> G06F3/01 <br> G02F1/1333 <br> G06F3/041 <br> H01L41/193 |
| Y | US 2018/136754 A1 (KIM SANG KOOK [KR] ET AL) 17 May 2018 (2018-05-17) <br> * paragraph [0003] - paragraph [0005] * <br> * paragraph [0040] - paragraph [0066] * <br> * paragraph [0089] - paragraph [0096] * <br> ----- | 1,2,8 | |
| Y | US 2010/141600 A1 (PARK SUNG-SOO [KR] ET AL) 10 June 2010 (2010-06-10) <br> * paragraph [0006] - paragraph [0009] * <br> * paragraph [0016] - paragraph [0025] * <br> ----- | 3-7 | |
| | | | TECHNICAL FIELDS SEARCHED (IPC) <br><br> G06F <br> G02F <br> H02N <br> H01L |

The present search report has been drawn up for all claims

| Place of search | Date of completion of the search | Examiner |
|---|---|---|
| Munich | 12 April 2019 | Agante da Silva, P |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
..............................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 18 20 5065

This annex lists the patent family members relating to the patent documents cited in the above-mentioned European search report.
The members are as contained in the European Patent Office EDP file on
The European Patent Office is in no way liable for these particulars which are merely given for the purpose of information.

12-04-2019

| Patent document cited in search report | | | Publication date | Patent family member(s) | | | Publication date |
|---|---|---|---|---|---|---|---|
| EP 3187973 | A1 | | 05-07-2017 | CN | 107085465 | A | 22-08-2017 |
| | | | | EP | 3187973 | A1 | 05-07-2017 |
| | | | | KR | 20170080291 | A | 10-07-2017 |
| | | | | US | 2017192509 | A1 | 06-07-2017 |
| US 2018136754 | A1 | | 17-05-2018 | KR | 20180054232 | A | 24-05-2018 |
| | | | | US | 2018136754 | A1 | 17-05-2018 |
| US 2010141600 | A1 | | 10-06-2010 | KR | 20100065637 | A | 17-06-2010 |
| | | | | US | 2010141600 | A1 | 10-06-2010 |

EPO FORM P0459

For more details about this annex : see Official Journal of the European Patent Office, No. 12/82